Europäisches Patentamt

European Patent Office

Office européen des brevets

(11) Publication number: 0 335 037
A1

# EUROPEAN PATENT APPLICATION

(21) Application number: 88309705.7

(22) Date of filing: 17.10.88

(51) Int. Cl.⁴: **H03C 1/00** , **H03D 1/22** , **H03D 3/00**

(30) Priority: 26.03.88 GB 8807272

(43) Date of publication of application:
04.10.89 Bulletin 89/40

(84) Designated Contracting States:
BE DE FR IT SE

(71) Applicant: STC PLC
10, Maltravers Street
London, WC2R 3HA(GB)

(72) Inventor: Masterton, John
43, Collins Cross
Bishop's Stortford Hertfordshire(GB)
Inventor: Gaskell, Philip Stuart
20, Courtyards
Little Shelford Cambridge CB2 5ER(GB)

(54) Direct conversion radio.

(57) A digital direct-conversion or zero-IF radio receiver in which analogue RF signals are down-converted to form a complex pair of analogue signals (I and Q) which are separately digitised and the digitised signals are digitally processed to produce an output signal. The digitising is performed by separate I and Q oversampling analogue-to-digital converters 17, 17a (ADC) operating at sampling rates not less than 10 times the Nyquist rate. The output of each oversampling ADC is applied to respective I and Q digital filters 18, 18a. The outputs of the I and Q digital filters are fed to a digital signal processor 19 to produce the output signal.

EP 0 335 037 A1

# DIRECT CONVERSION RADIO

This invention relates to digital direct conversion or zero-IF radios.

The benefits of the direct conversion or zero-IF type of radio are well known. British patent 1530602 discloses a zero-IF radio receiver that is particularly suitable for implementation in a single circuit chip having few off-chip components. The radio receiver of patent 1530602 is an analogue receiver for FM signals. For many applications it is beneficial to convert the zero-IF baseband signals into digital form for signal processing. This allows sophisticated receiver algorithms to be realised. Digital signal processing has the well-known advantages of programmability accuracy and reliability, and complex digital circuits can be integrated for a compact, low power realisation. A zero-IF radio receiver having digital signal processing is disclosed in British patent 2106734B.

In a digital zero-IF radio receiver the incoming RF is first down-converted to baseband by mixing the RF signal with two local oscillator signals in quadrature each running at the carrier frequency to produce a complex pair of signals I and Q. The I and Q signals are then separately digitised and digitally processed. To realise a radio receiver with high sensitivity and spurious-free dynamic range the digitised signals must have high resolution and linearity. In addition, the I and Q channels have to be closely matched to avoid distortion and spurious signals.

One of the most important parameters of an analogue-to-digital converter (ADC) in a digital radio receiver is its linearity. If the ADC has poor linearity large unwanted signals at low offset frequencies lead to spurious intermodulation signals, thereby limiting the spurious-free dynamic range of the receiver. With a conventional ADC the interference signals are removed by a sharp-cut analogue anti-alias filter and the ADC is sampled close to the Nyquist rate, i.e. twice the maximum wanted signal frequency. For large interference signals the anti-alias filter must have high stop-band suppression and this usually implies a high order circuit-occupying a large board area and possibly having a high power dissipation (for an active filter with the necessary linearity). Furthermore, sharp-cut filters have a non-linear phase response and matching between the I and Q filters is often poor.

According to the present invention there is provided a digital direct-conversion or zero-IF radio in which analogue RF signals are converted to or from digital baseband signals in quadrature, wherein the analogue-to-digital or digital-to-analogue conversion is performed by oversampling converters operating at sampling rates not less than 10 times the Nyquist rate.

In one embodiment of the invention there is provided a digital direct-conversion or zero-IF radio receiver in which analogue RF signals are down-converted to form analogue quadrature baseband (I and Q) signals which are separately digitised and the digitised signals are digitally processed to produce an output signal, wherein the digitising is performed by separate I and Q oversampling analogue-to-digital converters (ADC) operating at sampling rates not less than 10 times the Nyquist rate, the output of each oversampling ADC being applied to respective I and Q digital filters, the outputs of the I and Q digital filters being fed to a digital signal processor to produce the output signal.

Preferably the I and Q filters each include means for reducing the high sample rate of the ADC output to a low sample rate of less than 10 times the Nyquist rate.

In another embodiment of the invention there is provided a digital direct-conversion or zero-IF radio transmitter in which digitised quadrature baseband I and Q signals from a digital baseband modulator are separately converted by digital oversampling means into streams of data words of reduced wordwidth and applied to respective digital-to-analogue converters (DAC) the quadrature outputs of which are applied to reconstruction filters and are separately mixed with one or possibly two local oscillator signals running at the transmitter carrier frequency, the mixer outputs being combined to form an analogue RF output, wherein the sampling rate of the oversampling means is not less than 10 times the Nyquist rate.

Embodiments of the invention will now be described with reference to the accompanying drawings, in which:-

Figure 1 is a block diagram of a zero-IF radio receiver with oversampling ADC's,

Figure 2 is a block diagram illustrating an oversampling ADC configuration,

Figure 3 illustrates the effect of oversampling on quantising noise,

Figure 4 illustrates the effect of applying frequency dependent feedback to the ADC,

Figure 5 illustrates a pulse density modulator,

Figure 6 is a block diagram of a zero-IF radio transmitter with oversampling DAC's,

Figure 7 is a block diagram of an oversampling DAC configuration, and

Figure 8 illustrates the effect of the oversampled DAC output signal on noise and spectral image products.

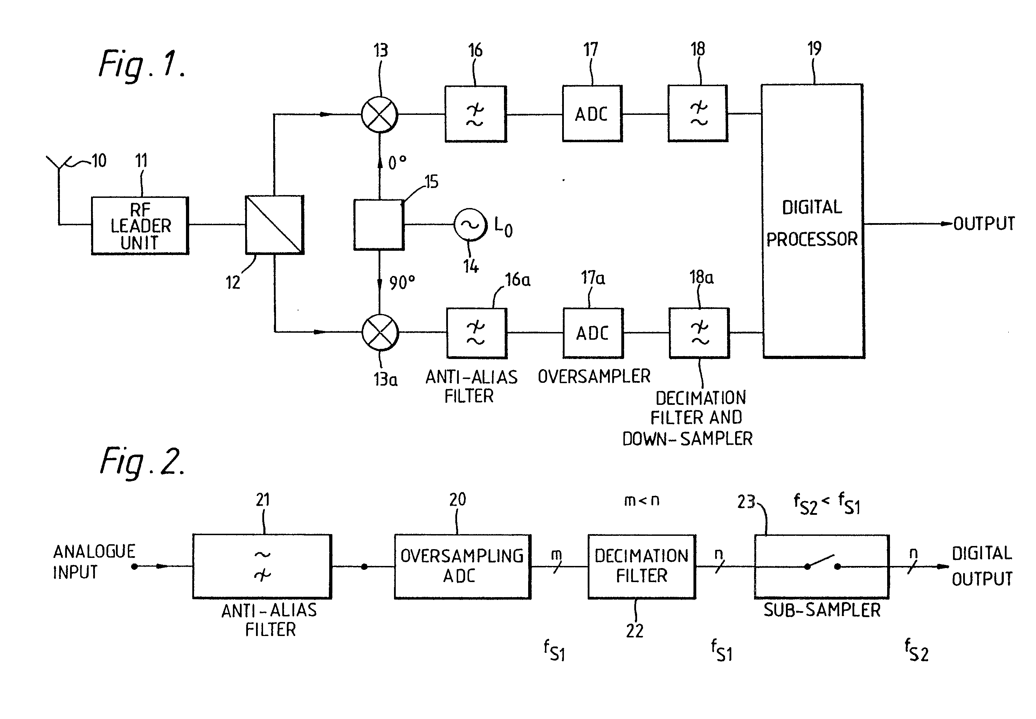

In the arrangement of Figure 1 analogue RF signals are received via an aerial 10 at an RF front end unit 11. The RF signals are applied to a signal splitter 12 and fed to mixers 13, 13a. A local oscillator 14 running at the RF carrier frequency feeds local oscillator signals in quadrature via a phase shifting network 15 to the mixers 13, 13a to form a complex pair of baseband signals I and Q. The I and Q signals are separately filtered by anti-alias filters 16, 16a and the filtered signals are applied to respective oversampling ADC's 17, 17a. The sampling rate of the ADC's is not less than 10 times the Nyquist rate and is typically 100 times the Nyquist rate. The resulting high speed digitised I and Q signals are applied to decimation filters and down-samplers 18, 18a to remove high frequency noise and reduce the sampling rate. Finally the reduced rate 1 and Q signals are aplied to a digital signal processor 19 to reproduce the original modulation signal applied to the RF signal at the transmitter. Note that as an alternative to the arrangement shown in Figure 1 the quadrature phase shift network may be introduced at the RF signal splitting stage 12 instead of in the local oscillator (LO) feed to the mixer. Also the phase shift may be effected as $\pm45°$ instead of $0°$ and $90°$ respectively.

The oversampling ADC 20,(Figure 2) takes the filtered analogue signal from the anti-aliasing filter 21 and produces $\underline{m}$ bit words at a sampling frequency $f_{si}$.

The decimation filter 21 increases the wordwidth to n bits with the sampling frequency remaining at $f_{s1}$. The n-bit words are then applied to the down-sampler 22 which samples the digital words at a sampling frequency $f_{s2}$ which is less than $f_{s1}$. Note that filtering and down-sampling operations may be combined.

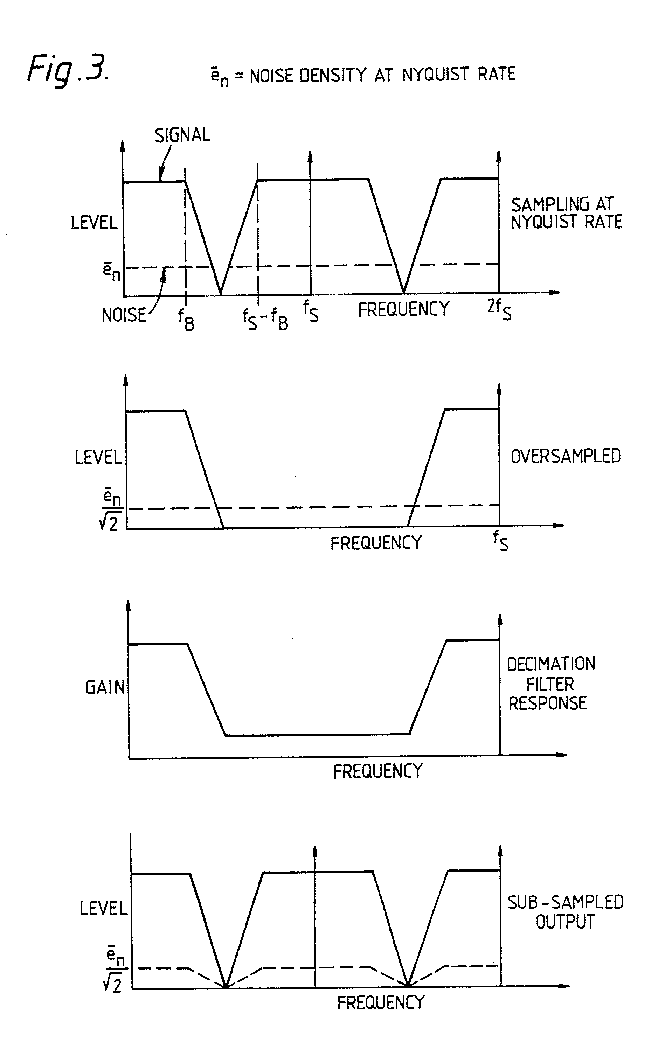

The wordwidth of the oversampled coder is usually less than that of the filter because of the property of ADC's that if the sampling rate is increased the wordwidth required to represent a given resolution is reduced. By digitally filtering the oversampled ADC output the net baseband noise is reduced as shown in Figure 3. Figure 3a is a plot of signal level against frequency, showing the noise density $e_n$ at the Nyquist rate. The signal bandwidth is $f_B$ and the Nyquist rate is just greater than $2f_B$. Figure 3b shows the effect of oversampling the signal where the noise density has fallen by 1/*2. Figure 3c shows the gain relative to frequency of the decimation filter, and Figure 3d shows the noise density when the sampling rate of the oversampled signal is reduced.

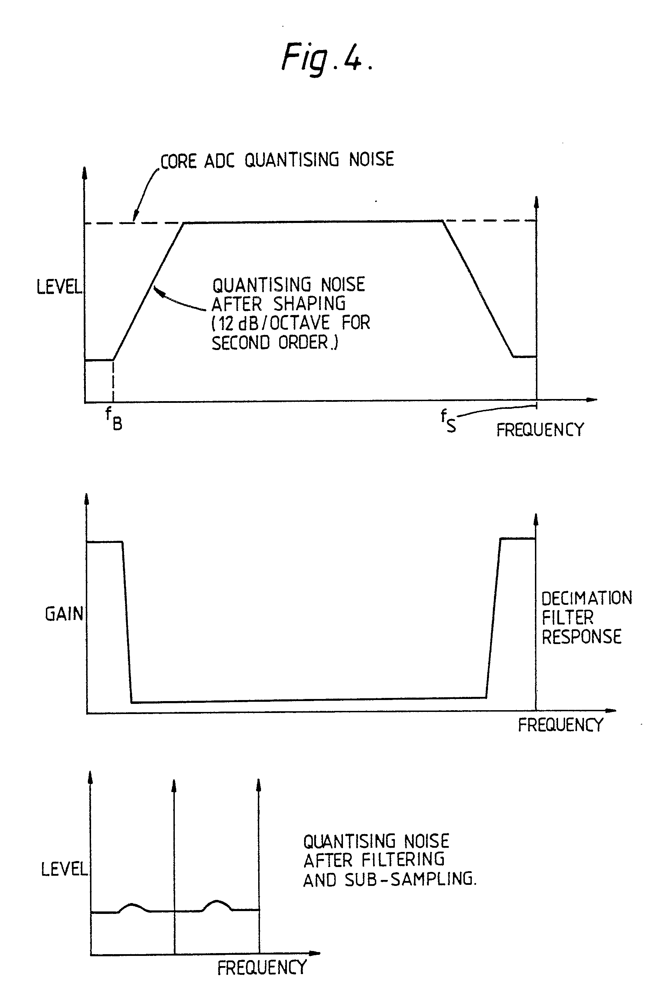

In addition to oversampling further noise reduction can be achieved by applying frequency-dependent feedback to the basic ADC. This shapes the noise so that it is reduced at baseband frequencies but rises at high frequencies. As before, this is followed by filtering and down-sampling as shown in Figure 4, with the same advantages. Figure 4a shows the level of quantising noise after shaping (12dB/octave for second order), $f_b$ being the signal bandwidth. Figure 4b shows the decimation filter response and Figure 4c shows the level of quantising noise after filtering and down-sampling.

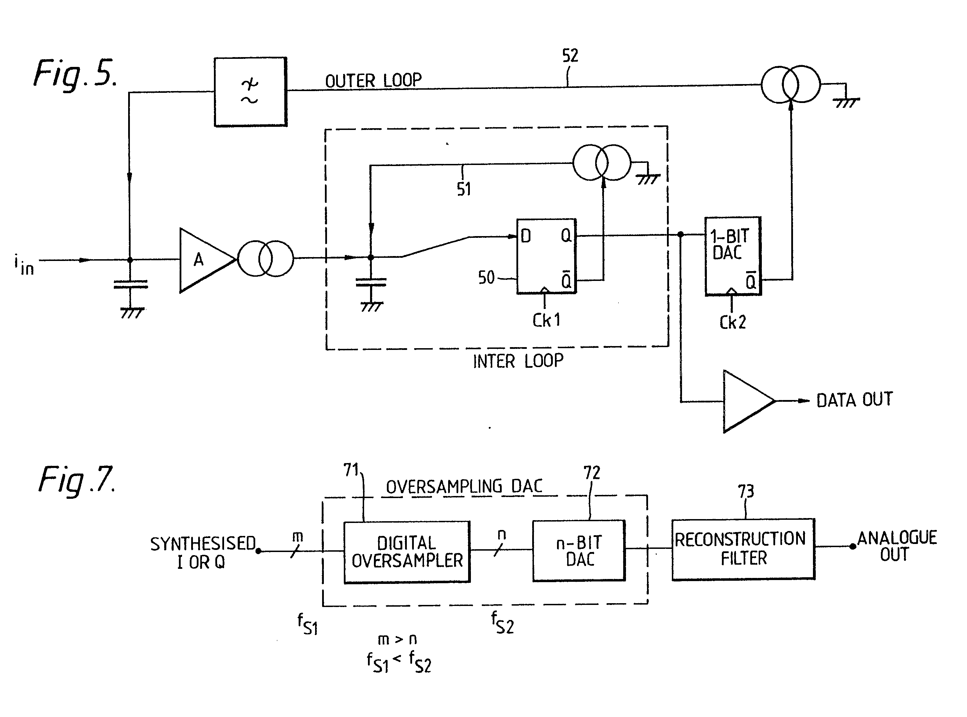

Various types of oversampling ADC exist and, although the same general advantages apply to all, the simple pulse density modulator ADC has specific advantages. The simplest form of pulse density modulator (PDM) has at its core a clocked D-type flip-flop 50, Figure 5. This has only a one-bit output. The quantising noise is shaped by second or higher order feedback circuits 51, 52 to give maximum resolution at baseband frequencies. Various configurations for PDM'S are disclosed in British patents 1, 450, 989; 1, 512, 612; and 2 111 332.

The one-bit oversampler generally gives superior linearity compared with oversamplers with more than one bit because of the difficulties of designing high speed, high linearity DAC's for the feedback loop of a noise shaped oversampler. It also has a simpler circuit, as can be seen from Figure 5, making integration in solid state circuitry easier.

For the purpose of the ADC the main filtering functions of the digital filter are

i) removal of high frequency noise generated by the ADC,

ii) down-sampling from a high input (oversampling) rate to a low output rate,

iii) increasing the sample wordwidth and resolution.

In a digital radio receiver the same filter may be used to perform additional functions with virtually the same hardware. These are:

i) interference signal rejection at high frequencies,

ii) receiver channel filtering.

Since the ADC is oversampled the analogue anti-alias filter (which attenuates high frequency signals which fold down into the baseband) can be of a very low order because its passband is narrow relative to the stop-band edge frequency. Residual interference signals that are not removed by the anti-alias filter are converted by the oversampled ADc and then suppressed by the digital filter. In effect, the sharp-cut analogue anti-alias filter of a conventional ADC is transferred to the digital domain.

The ADC is generally a simple circuit operating at high speed while the complex digital filter can be integrated using a VLSI low power process technology. The arrangement finds application in multi-mode modulation types, e.g. FM, AM, SSB, CW and of different bandwidth. The arrangement is also well suited to the reception of data-modulated signals such as FSK and MSK because of the linear properties of the oversampling ADC.

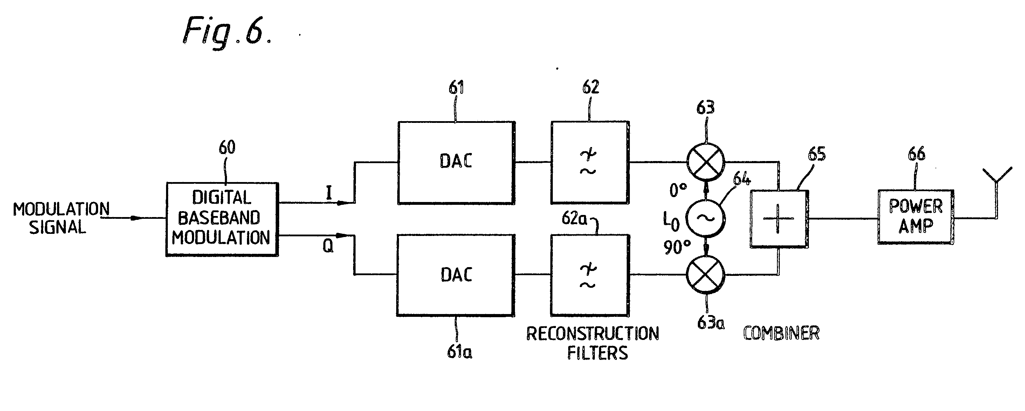

The oversampling technique is also adaptable for digital-to-analogue coders (DAC) and has particular advantages for zero-IF radio transmitters. A block diagram of a zero-IF transmitter is shown in Figure 6. The baseband I and Q quadrature signals are synthesised digitally in a digital baseband modulator 60 and represented by a parallel word. The parallel I and Q data streams are converted by oversampling DAC'S 61, 61a into streams of data words of reduced width which are fed to respective reconstruction filters 62, 62a. The filter outputs are separately mixed in mixers 63, 63a with two quadrature outputs from a local oscillator 64 and the mixer outputs are then combined in combiner 65 to form the RF signal to be fed to the transmitter antenna via power amplifier 66.

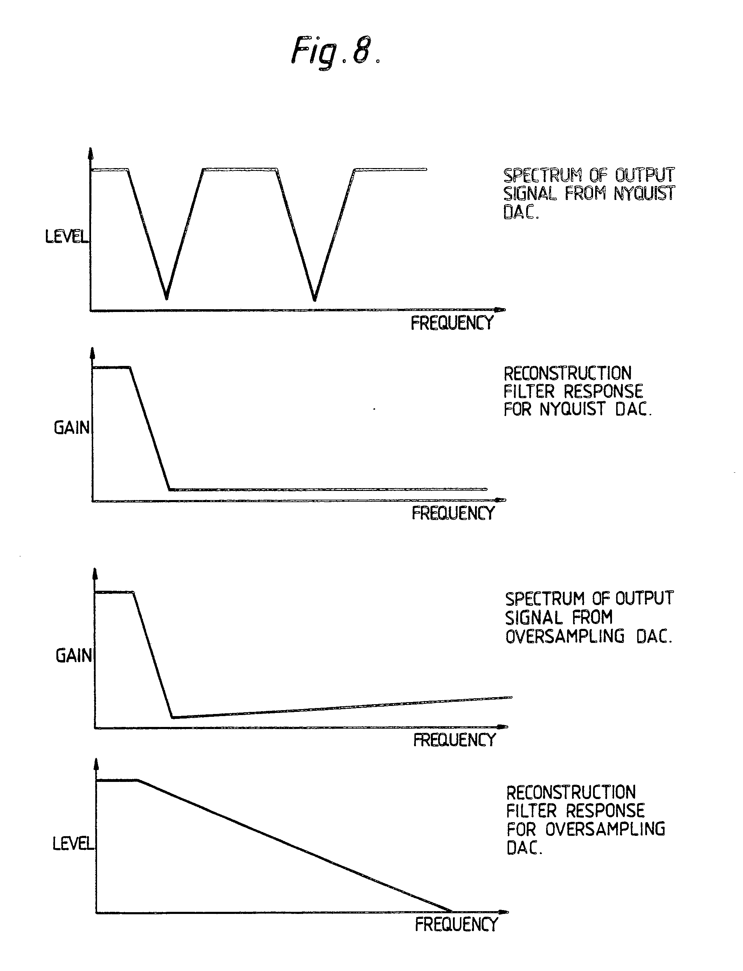

Figure 7 shows the elements of the oversampling DAC. The synthesised quadrature signal (I or Q) in the form of a stream of m-bit words at the Nyquist sample rate $f_{s1}$ is first applied to a digital oversampler 71 the output of which is a stream of n-bit words at a higher sample rate $f_{s2}$. $f_{s2}$ is usually considerably in excess of 10 times the Nyquist rate $f_{s1}$, e.g. 100 times, and the wordwidth m is usually much less than the input wordwidth $\overline{m}$. The n-bit words are applied to an n-bit DAC 72 the analogue output of which is fed to a reconstruction filter 73. In the case of a one-bit oversampler the final DAC consists simply of a pulse forming circuit.

Significant noise and spectral image products of the oversampling DAC output signal are at high offset frequencies, as shown in Figure 8, and can be removed by a simple analogue filter. This is in contrast to a conventional DAC sampling at or near the Nyquist rate and which requires a sharp-cut reconstruction filter which can occupy a large area of board space.

## Claims

1. A digital direct-conversion or zero-IF radio in which analogue RF signals are converted to or from digital baseband signals in quadrature, characterised in that the analogue-to-digital or digital-to-analogue conversion is performed by oversampling converters operating at sampling rates in excess of the Nyquist rate.

2. A digital direct-conversion or zero-IF radio receiver in which analogue RF signals are downconverted to form analogue quadrature baseband (I and Q) signals which are separately digitised and these digitised signals are digitally processed to produce an output signal, characterised in that the digitising is performed by separate I and Q oversampling analogue-to-digital converters (ADC) operating at sampling rates not less than 10 times the Nyquist rate, the output of each oversampling ADC being applied to respective I and Q digital filters, the outputs of the I and Q digital filters being fed to a digital signal processor to produce the output signal.

3. A receiver according to claim 2 characterised in that the I and Q filters each include means for reducing the high sample rate of the ADC output to a low sample rate of less than 10 times the Nyquist rate.

4. A receiver according to claim 2 or 3 characterised in that the ADC includes frequency-dependent feedback whereby the noise is reduced at baseband frequencies.

5. A receiver according to claim 2, 3 or 4 characterised in that the ADC comprises a pulse density modulator (PDM).

6. A receiver according to claim 5 characterised in that the PDM is a clocked D-type flip-flop.

7. A digital direct-conversion or zero-IF radio transmitter characterised in that digitised quadrature baseband I and Q signals from a digital baseband modulator are separately converted by digital oversampling means into streams of data words of reduced wordwidth and applied to respective digital-to-analogue converters (DAC) the outputs of which are passed through respective reconstruction filters and are separately mixed with two quadrature local oscillator signals running at the transmitter carrier frequency, the mixer outputs being combined to form an analogue RF output, characterised in that the sampling rate of the oversampling means is not less than 10 times the Nyquist rate.

8. A transmitter according to claim 7 characterised in that the DAC's are one-bit DAC's.

Fig. 1.

Fig. 2.

*Fig.3.*   $\bar{e}_n$ = NOISE DENSITY AT NYQUIST RATE

SIGNAL

LEVEL

$\bar{e}_n$

NOISE   $f_B$   $f_S - f_B$   $f_S$   FREQUENCY   $2f_S$   SAMPLING AT NYQUIST RATE

LEVEL

$\dfrac{\bar{e}_n}{\sqrt{2}}$

FREQUENCY   $f_S$   OVERSAMPLED

GAIN

FREQUENCY   DECIMATION FILTER RESPONSE

LEVEL

$\dfrac{\bar{e}_n}{\sqrt{2}}$

FREQUENCY   SUB-SAMPLED OUTPUT

# Fig.4.

CORE ADC QUANTISING NOISE

LEVEL

QUANTISING NOISE
AFTER SHAPING
(12 dB/OCTAVE FOR
SECOND ORDER.)

$f_B$          $f_S$     FREQUENCY

GAIN

DECIMATION
FILTER
RESPONSE

FREQUENCY

LEVEL

QUANTISING NOISE
AFTER FILTERING
AND SUB-SAMPLING.

FREQUENCY

Fig. 5.

Fig. 7.

## Fig.6.

MODULATION SIGNAL →

DIGITAL BASEBAND MODULATION  *60*

I →

Q →

DAC  *61*

DAC  *61a*

⌇ ~  *62*

⌇ ~  *62a*

RECONSTRUCTION FILTERS

⊗ 0°  *63*

L₀ ~  *64*

⊗ 90°  *63a*

+ *65*  COMBINER

POWER AMP  *66*

EP 0 335 037 A1

# Fig.8.

SPECTRUM OF OUTPUT
SIGNAL FROM NYQUIST
DAC.

RECONSTRUCTION
FILTER RESPONSE
FOR NYQUIST DAC.

SPECTRUM OF OUTPUT
SIGNAL FROM
OVERSAMPLING DAC.

RECONSTRUCTION
FILTER RESPONSE
FOR OVERSAMPLING
DAC.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| E | EP-A-0 310 796 (BBC BROWN BOVERY) * Page 4, lines 48-53; figures 1-4b * | 1 | H 03 C 1/00 H 03 D 1/22 H 03 D 3/00 |
| X | EP-A-0 186 568 (FAIRCHILD WESTON SYSTEMS INC.) * Page 6, line 26 - page 10, line 15; figures 2-6 * | 1 | |
| A | EP-A-0 143 539 (STC PLC) * Whole document * | 2,5 | |
| A | EP-A-0 197 708 (STC PLC) * Page 2, ligne 29 - page 4, ligne 10; figures 1,2 * | 2 | |
| A | EP-A-0 180 339 (STC PLC) * Page 3, line 1 - page 4, line 11; page 6, line 24 - page 7, line 14; figures 1,2,8-11 * | 2,7 | |
| A | WO-A-8 605 936 (MOTOROLA) * Page 26, line 1- page 28, line 15; figures 16,17 * | 2,3,7 | TECHNICAL FIELDS SEARCHED (Int. Cl.4) H 03 D H 03 C H 04 B |

The present search report has been drawn up for all claims

| Place of search | Date of completion of the search | Examiner |
|---|---|---|
| THE HAGUE | 30-05-1989 | BALBINOT H. |